(19) Europäisches Patentamt
European Patent Office
Office européen des brevets

(11) **EP 0 980 003 B1**

(12) **EUROPÄISCHE PATENTSCHRIFT**

(45) Veröffentlichungstag und Bekanntmachung des Hinweises auf die Patenterteilung:
**08.03.2006   Patentblatt 2006/10**

(51) Int Cl.:
***G01R 15/06*** (2006.01)

(21) Anmeldenummer: **99810721.3**

(22) Anmeldetag: **11.08.1999**

(54) **RC-Spannungsteiler**

RC voltage divider

Diviseur de tension RC

(84) Benannte Vertragsstaaten:
**AT BE CH CY DE DK ES FI FR GB GR IE IT LI LU MC NL PT SE**

(30) Priorität: **12.08.1998   CH 165998**

(43) Veröffentlichungstag der Anmeldung:
**16.02.2000   Patentblatt 2000/07**

(73) Patentinhaber: **Trench Switzerland AG**
**4028 Basel (CH)**

(72) Erfinder:
• **Minkner, Ruthard Dr. Ing.**
**CH 4148 Pfeffingen (CH)**
• **Wolf, Franz Josef Masch. Ing.**
**79650 Schopfheim (DE)**
• **Pajer, Jaroslav El. Techn. HTL**
**CH-4153 Reinach (CH)**

• **Schmid, Joachim Dr. Ing.**
**79588 Efringen-Kirchen (DE)**
• **Gross, Reimund Dipl. Ing.**
**79618 Rheinfelden (DE)**

(74) Vertreter: **Bollhalder, Renato et al**
**A. Braun**
**Braun Héritier Eschmann AG**
**Patentanwälte VSP**
**Holbeinstrasse 36-38**
**4051 Basel (CH)**

(56) Entgegenhaltungen:
DE-A- 19 508 582          FR-A- 2 462 713
US-A- 5 495 387

• **PATENT ABSTRACTS OF JAPAN vol. 15, no. 402 (P-1262), 14. Oktober 1991 (1991-10-14) & JP 03 163365 A (FUJI ELECTRIC), 15. Juli 1991 (1991-07-15)**

**Beschreibung**

Die Erfindung betrifft einen RC-Spannungsteiler für die Messung der Primärspannung Up zwischen Phase und Erde oder zwischen Phase und Nullleiter in Ein-, Zwei- und Dreiphasensystemen, mit einem Primärteil und einem Sekundärteil.

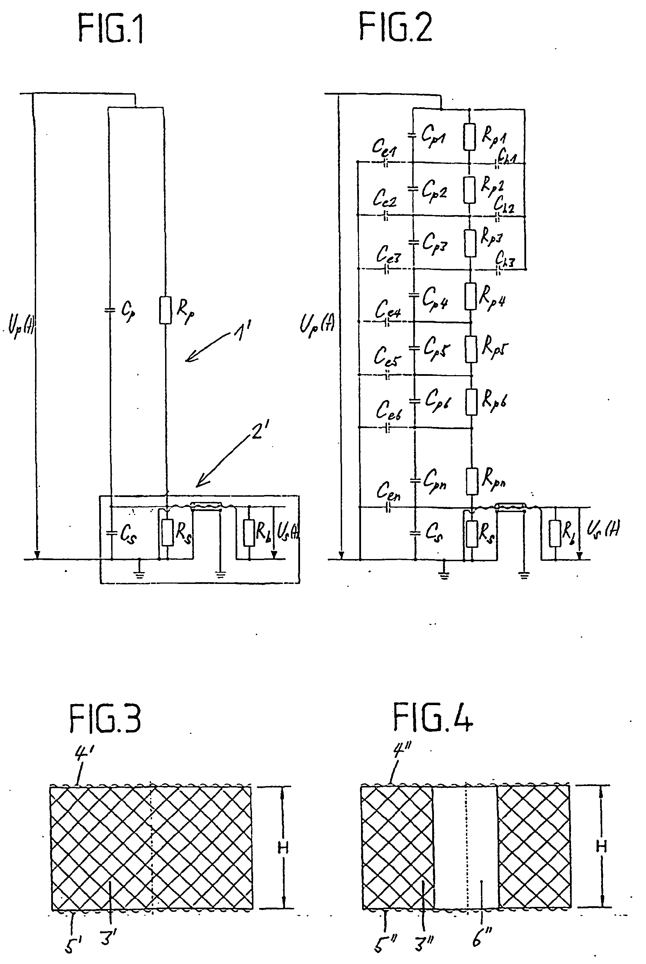

Fig. 1 zeigt das Prinzipschema eines RC-Spannungsteilers, wobei $R_p$ der Gesamtwiderstand des Primärteils 1', $C_p$ die zu $R_p$ parallele Gesamtkapazität des Primärteils 1', $R_s$ der Widerstand des Sekundärteils 2' und $C_s$ die zu $R_s$ parallele Kapazität des Sekundärteils 2' sind. Es ist bekannt, dass für frequenzunabhängige RC-Spannungsteiler die Beziehung $R_p \times C_p = R_s \times C_s$ gelten muss.

Am Sekundärteil wird die Sekundärspannung $U_s$(t) für die Signalverarbeitung an der Burde $R_b$, die der Eingangsimpedanz der angeschlossenen Schutzrelais und Zähler entspricht, abgenommen, wobei die Sekundärspannung $U_s$(t) durch die Beziehung

$$\underline{U}_s = \frac{\underline{Z}_s}{\underline{Z}_s + \underline{Z}_p} \cdot \underline{U}_p$$

mit der zu messenden Primärspannung $\underline{U}_p$ verknüpft ist. Die komplexen und frequenzabhängigen Widerstände $\underline{Z}_s$ und $\underline{Z}_p$ sind durch die Parallelschaltungen von $R_s \| C_s$ bzw. $R_p \| C_p$ gegeben. In der Praxis werden die Kapazitätswerte von $C_p$ und $C_s$ nach den immer vorhandenen Streukapazitäten $C_e$ gegen Erde und $C_h$ gegen Hochspannungsabschirmung und Hochspannungsanschluss dimensioniert, um den Anforderungen an den Frequenzgang des Spannungsteilers zu genügen.

Fig. 2 zeigt ein Ersatzschaltbild eines RC-Spannungsteilers mit Primärwiderständen $R_{p1}$ - $R_{pn}$, Primärkapazitäten $C_{p1}$ - $C_{pn}$, Sekundärwiderstand $R_s$, Sekundärkapazität $C_s$ und Burde $R_b$, in dem Streukapazitäten $C_{e1}$- $C_{e1n}$ und $C_{h1}$ - $C_{h3}$ eingezeichnet sind. Die Kapazitäten $C_{h1}$ - $C_{h3}$ kompensieren je nach Grösse teilweise den Einfluss von $C_{e1}$ - $C_{e1n}$ auf das Frequenzverhalten.

Die bisher bekannten RC-Spannungsteiler für den Spannungsbereich 72 kV - 765 kV setzen sich aus Kondensatorelementen und aus einzelnen Widerständen zusammen. Um mit den Kondensatorelementen eine hohe Längskapazität $C_p$ gegenüber den Erdkapazitäten $C_e$ zu erreichen, werden gewickelte Folienkondensatoren, die mit Gas (z.B. $SF_6$ oder Luft) oder mit einer Isolierflüssigkeit imprägniert sind, eingesetzt. Für die zu den Kondensatoren parallelen Hochspannungswiderstände $R_{p1}$ - $R_{pn}$ werden stabile Widerstände, z.B. Dickschichtwiderstände oder Drahtwiderstände mit kleinem Temperaturkoeffizient TK, verwendet, um auch bei Temperaturunterschieden längs des RC-Spannungsteilers ein stabiles Teilerverhältnis zu erhalten.

Bei der Dickschichttechnologie werden die Widerstände auf flache oder runde Keramikträger aufgebracht und die Widerstandsschichten werden bei hoher Temperatur in den Träger eingebrannt. Die Widerstandsstruktur kann durch eine Glas- oder Farbschicht geschützt werden.

Bei den heute hergestellten RC-Spannungsteilern für Mess- und Schutzzwecke in Wechsel- und Gleichspannungsnetzen basieren die eingesetzten Kondensatoren auf einer aufwendigen Technologie und der Zusammenbau von Kondensatoren und Widerständen ist zeitaufwendig. Für gasisolierte Schaltanlagen besteht ausserdem die Forderung, dass nur trockene Kondensatoren, d.h. mit Gas imprägnierte Folien- oder Filmkondensatoren, eingesetzt werden. Die Prozesse der Kondensatorwickelherstellung und der Gasimprägnierung, die eine hohe Feldstärke zulassen, was gleichbedeutend mit kostengünstigen Kondensatoren ist, und die für eine Lebensdauer von 25 Jahren mit hoher Zuverlässigkeit notwendig sind, sind sehr komplex und teuer.

In Folge der Entwicklung von Keramikmaterial mit höheren relativen Permittivitäten $\varepsilon_r$ als die Standardkeramik mit $\varepsilon_r$-Werten von 6 bis 10 werden nun auch keramische Hochspannungskondensatoren gebaut. Die relative Permittivität $\varepsilon_r$ kann, je nach Material, Werte von 10 bis 3000 haben.

Keramische Kondensatoren wurden bereits für die Verbesserung des Frequenzverhaltens und der Spannungssteuerung von ohmschen Stossspannungsteilern eingesetzt. Bei diesen Stossspannungsteilern handelt es sich um eine Konstruktion aus separaten Widerständen und Kondensatorelementen. Zwei Arten von verwendeten keramischen Kondensatoren sind in den Fig. 3 und 4 abgebildet.

Fig. 3 zeigt einen zylindrischen Vollkern-Kondensator mit einem Keramikträger 3', dessen beiden Stirnflächen mit einer Metallisierung 4' bzw. 5' versehen sind, während in Fig. 4 ein zylindrischer Hohlkern-Kondensator mit einem eine zentrale Bohrung 6" aufweisenden Keramikträger 3" mit Metallisierungen 4" und 5" an den Stirnflächen dargestellt ist. Werden derartige keramische Kondensatoren in Isoliergas $SF_6$ eingebaut, kann ihre Höhe H stark reduziert werden, so dass sich kompakte Keramikkondensatoren herstellen lassen.

In der US 5 495 387 A sind RC-Module offenbart, die einen laminierten Keramikblock mit Kondensatorelektroden im Innern aufweisen. Aussen auf dem Keramikblock sind Dünnschichtwiderstände und Anschlusselektroden angeordnet. Diese RC-Module dienen als Hochfrequenzfilter.

Aus der JP 03 163365 A ist ein RC-Spannungsteiler bekannt, der keramische Kondensatoren sowie separat angeordnete Widerstände umfasst.

Angesichts der Nachteile der bisher bekannten, oben beschriebenen RC-Spannungsteiler liegt der Erfindung die Aufgabe zugrunde, einen RC-Spannungsteiler der eingangs erwähnten Art zu schaffen, der einfach und kostengünstig herstellbar und montierbar ist.

Diese Aufgabe wird durch den erfindungsgemässen RC-Spannungsteiler gelöst, wie er im unabhängigen Patentanspruch 1 definiert ist. Bevorzugte Ausführungsvarianten ergeben sich aus den abhängigen Patentansprüchen.

Das Wesen der Erfindung besteht darin, dass bei einem RC-Spannungsteiler für die Messung der Primärspannung Up zwischen Phase und Erde oder zwischen Phase und Nullleiter in Ein-, Zwei- und Dreiphasensystemen, mit einem Primärteil und einem Sekundärteil, der Primärteil mindestens ein RC-Modul mit einem keramischen Kondensator und mindestens einem in die Oberfläche des keramischen Kondensators integrierten Dickschichtwiderstand aufweist.

Der Primärteil des RC-Spannungsteilers kann aus mehreren einzelnen RC-Modulen aufgebaut sein.

Durch die Integration des mindestens einen Widerstands in den mindestens einen keramischen Kondensator wird die Anzahl der Einzelteile im RC-Spannungsteiler reduziert. Die Herstellung und Montage wird damit erheblich einfacher und kostengünstiger. Der RC-Spannungsteiler kann auch kompakter gebaut werden.

Erfindungsgemäss integrierte RC-Module können zum Aufbau von RC-Spannungsteilern beliebiger Systemspannung verwendet werden, mit denen Spannungen im Frequenzbereich von 0 bis 5 MHz messbar sind. Ein weiterer Vorteil ist, dass nach dem Einbau in eine gasisolierte Schaltanlage keine zusätzlichen Prozesse mehr notwendig sind.

Im folgenden wird der erfindungsgemässe RC-Spannungsteiler unter Bezugnahme auf die beigefügten Zeichnungen und anhand von drei Ausführungsbeispielen detaillierter beschrieben. Es zeigen:

Fig. 5 -    schematisch einen RC-Spannungsteiler mit einem Primärteil mit sechs und einem Sekundärteil mit einem integrierten RC-Modul;

Fig. 6 -    ein erstes Ausführungsbeispiel eines zylindrischen RC-Moduls mit mäanderförmigen Widerstandsbahnen und metallischen Anschlüssen an der Zylindermantelfläche;

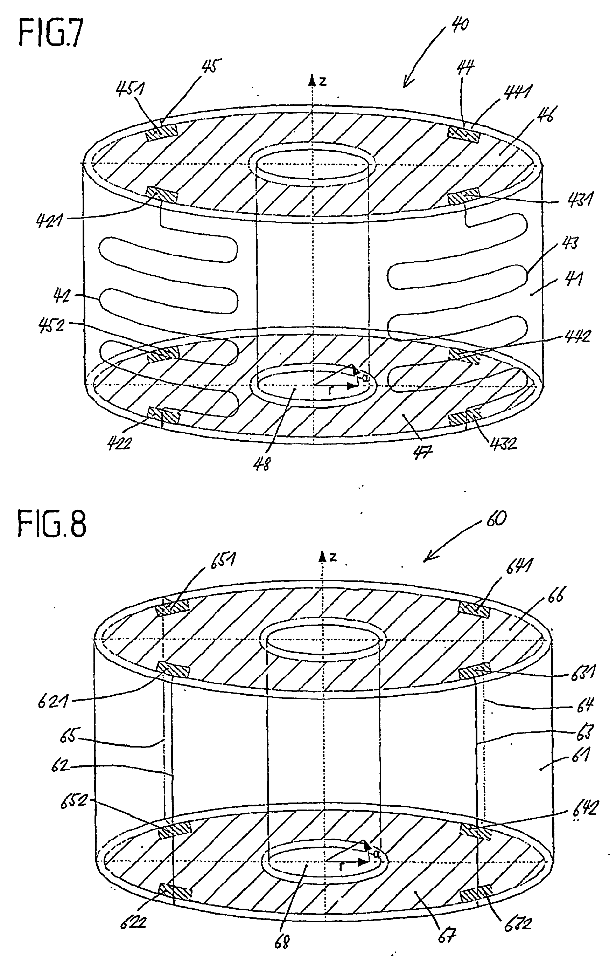

Fig. 7 -    ein zweites Ausführungsbeispiel eines zylindrischen RC-Moduls mit mäanderförmigen Widerstandsbahnen und metallischen Anschlüssen an den Zylinderstirnflächen;

Fig. 8 -    ein drittes Ausführungsbeispiel eines zylindrischen RC-Moduls mit geradlinigen Widerstandsbahnen und metallischen Anschlüssen an den Zylinderstirnflächen;

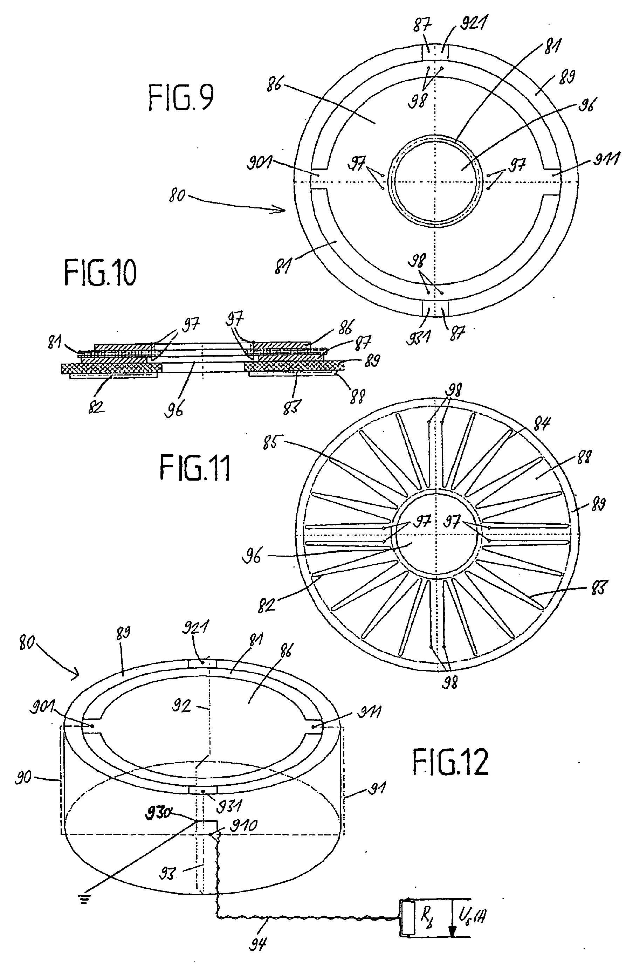

Fig. 9 -    ein Draufsicht auf das RC-Modul des Sekundärteils des RC-Spannungsteilers von Fig. 5.

Fig. 10 -    eine Schnittansicht des RC-Moduls von Fig. 9;

Fig. 11 -    eine Ansicht von unten des RC-Moduls von Fig. 9; und

Fig. 12 -    teilweise schematisch den Sekundärteil des RC-Spannungsteilers von Fig. 5 mit Anschlussverdrahtung.

### Figur 5

Der dargestellte erfindungsgemässe RC-Spannungsteiler umfasst einen Primärteil 1 und einen Sekundärteil 2 inklusive Anschlussverdrahtung und ist zur Isolation gegen aussen in einem Isoliergas 3, vorzugsweise $SF_6$-Gas, angeordnet. Der Primärteil 1 besteht aus sechs hohlzylindrischen RC-Modulen 20, zwischen denen Potentialringe 11 angeordnet sind, und ist mit einem metallischen Hochspannungsanschluss 12 versehen, zwischen den und Erde die zu messende Primärspannung $U_p(t)$ angelegt wird. Die RC-Module 20, die weiter unten im Detail beschrieben werden, weisen an ihren beiden Stirnflächen jeweils Metallisierungen 26 bzw. 27 auf, die zusammen mit den metallischen Potentialringen 11 für eine Vergleichmässigung des elektrischen Feldes sorgen. Die Widerstände sind nicht eingezeichnet.

Der Sekundärteil 2 umfasst ein einziges RC-Modul 80 mit Metallisierungen 86 und 87, das ebenfalls weiter unten detailliert beschrieben wird und unterhalb des untersten RC-Moduls 20 des Primärteils 1 angeordnet ist, wobei ein weiterer Potentialring 11 dazwischen liegt. Auch hier sind die Widerstände nicht eingezeichnet.

Eine verdrillte Messleitung 94, die mit einer einfachen oder zweifachen Abschirmung 95 versehen ist, verbindet den Sekundärteil 2 mit der Eingangsimpedanz des Verbrauchers bzw. Burde $R_b$, über der die Sekundärspannung $U_s(t)$ gemessen wird.

Für die gesamte weitere Beschreibung gilt folgende Festlegung. Sind in einer Figur zum Zweck zeichnerischer Eindeutigkeit Bezugszeichen enthalten, aber im unmittelbar zugehörigen Beschreibungstext nicht erläutert, so wird auf deren Erwähnung in vorangehenden Figurenbeschreibungen Bezug genommen.

### Figur 6

Das RC-Modul 20 umfasst einen zylindrischen keramischen Kondensator 21 mit einem Hohlkern 28 und Metallisierungen 26 und 27 an den Stirnflächen. In die Mantelfläche des keramischen Kondensators 21 eingebrannt sind vier symmetrisch angeordnete, in mäanderförmigen Bahnen verlaufende Dickschichtwiderstände mit einer Dicke von vorzugsweise zwischen 5 und 20 µm, wobei hier nur die Dickschichtwiderstände 22 und 23 sichtbar sind. Die Dickschichtwiderstandsbahnen weisen jeweils an ihren beiden Enden metallische Anschlüsse auf, die die Dickschichtwiderstände mit den Metallisierungen 26 und 27 elektrisch verbinden und von denen hier die metallischen Anschlüsse 221, 222, 231 und 232 sichtbar sind. Die metallischen Anschlüsse können beispielsweise halbkreisförmig, wie die Anschlüsse 231 und 232, oder rechteckig, wie die Anschlüsse 221 und 222, ausgebildet sein. Unabhängig von ihrer Form stellen diese metallischen Anschlüsse eine ideale Gleitfunkenstrecke dar, die bei zu hoher Spannung anspricht und einen Überschlag längs der Oberfläche des keramischen Kondensators 21 von Anschluss zu Anschluss desselben Dickschichtwiderstands, beispielsweise von Anschluss 221 zu Anschluss 222 oder von Anschluss 231 zu Anschluss 232 etc., zur Folge hat.

Die Höhe H des RC-Moduls 20 sollte so gewählt werden, dass der effektive Ionisationskoeffizient

$$\overline{\alpha} = f(\vec{E}, p) < 0$$ ist. $\vec{E}$ ist der Scheitelwert der Feldstärke der Anschlussstruktur der Dickschichtwiderstände auf der Oberfläche der Dickschichtwiderstände und p der herrschende Gasdruck des das RC-Modul 20 umgebenden Gases (z.B. Isoliergas SF$_6$).

Figur 7

Das RC-Modul 40 gemäss dem dargestellten zweiten Ausführungsbeispiel ist ähnlich aufgebaut wie das RC-Modul 20, d.h. es umfasst einen zylindrischen keramischen Kondensator 41 mit einem Hohlkern 48, Metallisierungen 46 und 47 an den Stirnflächen sowie vier in die Mantelfläche des keramischen Kondensators 41 eingebrannte, symmetrisch angeordnete, in mäanderförmigen Bahnen verlaufende Dickschichtwiderstände 42-45 mit metallischen Anschlüssen 421, 422, 431, 432, 441, 442, 451 und 452.

Im Unterschied zum RC-Modul 20 lassen die Metallisierungen 46 und 47 beim RC-Modul 40 am inneren und äusseren Rand der Stirnflächen des Kondensatorzylinders 41 je eine nichtleitende Ringfläche frei. Die Dickschichtwiderstände 42-45 sind über die obere und untere Kante des zylindrischen Kondensators 41 gezogen und oben und unten mit den Metallisierungen 46 bzw. 47 verbunden. Die metallischen Anschlüsse 421, 422, 431, 432, 441, 442, 451 und 452 sind an den Zylinderstirnflächen angeordnet. Auf diese Weise können Gleitfunkenstrecken vermieden werden.

Figur 8

Das RC-Modul 60 gemäss dem dargestellten dritten Ausführungsbeispiel ist ähnlich aufgebaut wie das RC-Modul 40, d.h. es umfasst einen zylindrischen keramischen Kondensator 61 mit einem Hohlkern 68, Metallisierungen 66 und 67 an den Stirnflächen sowie vier in die Mantelfläche des keramischen Kondensators 61 eingebrannte, symmetrisch angeordnete Dickschichtwiderstände 62-65, die über die obere und untere Kante des zylindrischen Kondensators 61 gezogen und mit an den Zylinderstirnflächen angeordneten metallischen Anschlüssen 621, 622, 631, 632, 641, 642, 651 und 652 versehen sind.

Im Unterschied zum RC-Modul 40 verlaufen die Widerstandsbahnen beim RC-Modul 60 geradlinig in z-Richtung, was eine günstigere Feldstärkebeanspruchung der Oberfläche des RC-Moduls zur Folge hat.

Je nach spezifischem Widerstand der eingesetzten Dickschichtpaste können die Widerstandsbahnen auch anders angeordnet werden als bei den RC-Modulen 20, 40 und 60, um eine möglichst günstige Feldstärkebeanspruchung der Oberfläche des RC-Moduls zu erhalten. Ausserdem können anstatt vier auch zwei, sechs, acht oder eine andere Anzahl von Widerstandsbahnen verwendet werden. Die optimalsten Widerstandsbahnen auf der Keramikoberfläche sind diejenigen, die zu keiner Erhöhung der Oberflächenfeldstärke in z- oder $\alpha$-Richtung führen. Es ist auch möglich, die gesamte Zylindermantelfläche des keramischen Kondensators mit einer flächendeckenden Widerstandsschicht zu versehen.

Figuren 9 bis 11

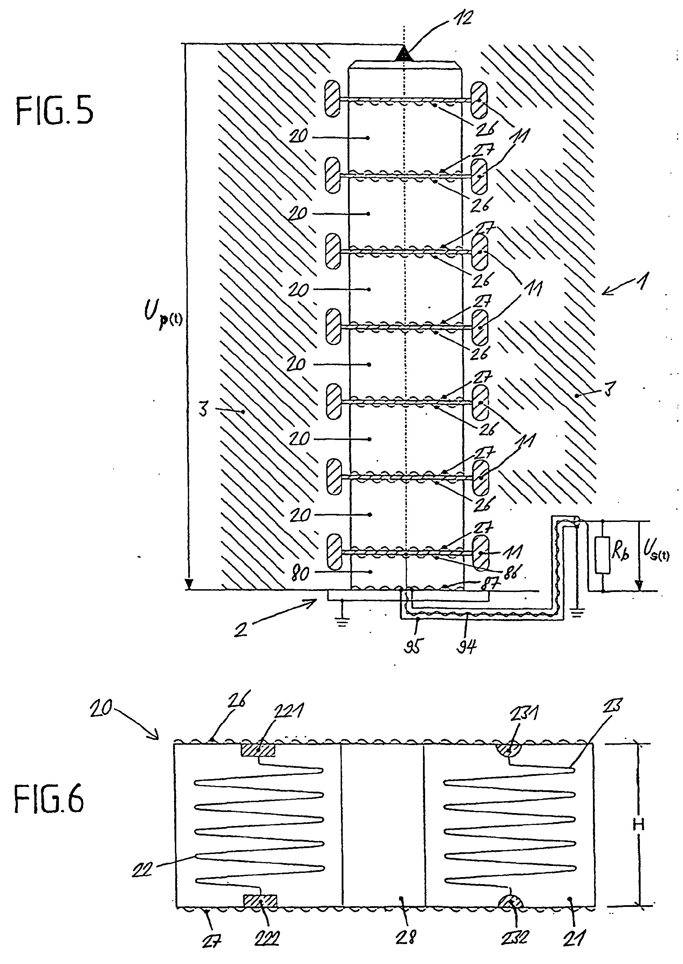

Das einen Hohlkern 96 aufweisende RC-Modul 80 des Sekundärteils 2 des RC-Spannungsteilers von Fig. 5 umfasst einen scheibenförmigen keramischen Kondensator 81, dessen beiden Flachseiten mit Metallisierungen 86 bzw. 87 als Potentialflächen versehen sind. Auf der dem keramischen Kondensator 81 abgewandten Seite der Metallisierung 87 ist ein Keramikträger 89 angeordnet, in dessen untere Oberfläche vier symmetrisch angeordnete, mäanderformige Dickschichtwiderstände 82-85 eingebrannt sind. Zum Schutz der Dickschichtwiderstände ist eine Glasschicht 88 aufgebracht.

Die Metallisierung 86 und damit der keramische Kondensator 81 ist über vier symmetrisch angeordnete Durchkontaktierungen 97 mit den Dickschichtwiderständen 82-85 elektrisch verbunden. Das erdseitige Ende des keramischen Kondensators 81 ist über vier Durchkontaktierungen 98 mit den erdseitigen Enden der Dickschichtwiderstände 82-85 verbunden. Zur Erdung des keramischen Kondensators 81 sind Erdanschlüsse 921 und 931 an der Metallisierung 87 vorgesehen. An der Metallisierung 86 sind zwei Anschlüsse 901, 911 für die Sekundärspannung U$_s$(t) angebracht.

Aus EMV-Gründen ist das RC-Modul 80 symmetrisch aufgebaut, so dass eine Induzierung von Störspannungen durch magnetische Felder ausgeschlossen werden kann.

Figur 12

Der Sekundärteil 2 des RC-Spannungsteilers von Fig. 5 weist für die Abnahme der Sekundärspannung U$_s$ eine symmetrische Anschlussverdrahtung auf, die von den Anschlüssen 901 bzw. 911 zu einem Verbindungsknoten 910 führende Verbindungsleitungen 90 bzw. 91 und von den Anschlüssen 921 bzw. 931 zu einem Verbindungsknoten 930 führende Verbindungsleitungen 92 bzw. 93 umfasst. Die Verbindungsleitungen 90-93 verlaufen aussen am RC-Modul 80 von den an dessen Oberseite angeordneten Anschlüssen 901, 911, 921, 930 zu den an dessen Unterseite angeordneten Verbindungsknoten 910, 930. An die Verbindungsknoten 910 und 930 ist eine verdrillte Messleitung 94 angeschlossen, die üblicherweise mit einer einfachen oder zweifachen geerdeten Abschirmung versehen ist und zur Burde $R_b$ führt. An der Burde $R_b$ wird die Sekundärspannung $U_s(t)$ für die Signalverarbeitung abgegriffen.

Eine derartige Anschlussausführung garantiert einen sehr tiefen Störspannungspegel.

Zu den vorbeschriebenen Ausführungsbeispielen sind weitere konstruktive Variationen realisierbar. Hier ausdrücklich erwähnt sei noch, dass das RC-Modul des Sekundärteils 2 auch entsprechend den RC-Modulen des Primärteils 1 aufgebaut sein kann.

## Patentansprüche

1. RC-Spannungsteiler für die Messung der Primärspannung $U_p$ zwischen Phase und Erde oder zwischen Phase und Nullleiter in Ein-, Zwei- und Dreiphasensystemen, mit einem Primärteil (1) und einem Sekundärteil (2), **dadurch gekennzeichnet, dass** der Primärteil (1) mindestens ein RC-Modul (20; 40; 60) mit einem keramischen Kondensator (21; 41; 61) und mindestens einem in die Oberfläche des keramischen Kondensators (21; 41; 61) integrierten Dickschichtwiderstand (22, 23; 42-45; 62-65) aufweist.

2. RC-Spannungsteiler nach Anspruch 1, **dadurch gekennzeichnet, dass** der oder die Dickschichtwiderstände (22, 23; 42-45; 62-65) in die Oberfläche des keramischen Kondensators (21; 41; 61) eingebrannt sind und vorzugsweise mäanderförmig verlaufen.

3. RC-Spannungsteiler nach Anspruch 1 oder 2, **dadurch gekennzeichnet, dass** der keramische Kondensator (21; 41; 61) als Vollkern- oder Hohlkernzylinder ausgebildet ist, wobei die beiden Stirnflächen des Zylinders vorzugsweise eine Metallisierung (26, 27; 46, 47; 66, 67) aufweisen.

4. RC-Spannungsteiler nach Anspruch 3, **dadurch gekennzeichnet, dass** der oder die Dickschichtwiderstände (22, 23) in der Zylindermantelfläche des keramischen Kondensators (21) verlaufen, insbesondere geradlinig von der einen Stirnfläche zur anderen und senkrecht zu den beiden Stirnflächen, und metallische Anschlüsse (221, 222, 231, 232) aufweisen.

5. RC-Spannungsteiler nach Anspruch 3, **dadurch gekennzeichnet, dass** der oder die Dickschichtwiderstände (42-45; 62-65) im wesentlichen in der Zylindermantelfläche des keramischen Kondensators (41; 61) verlaufen, insbesondere geradlinig von der einen Stirnfläche zur anderen und senkrecht zu den beiden Stirnflächen, und an den Stirnflächen angeordnete metallische Anschlüsse (421, 422, 431, 432, 441, 442, 451, 452; 621, 622, 631, 632, 641, 642, 651, 652) aufweisen.

6. RC-Spannungsteiler nach einem der Ansprüche 1 bis 5, **dadurch gekennzeichnet, dass** der Sekundärteil (2) ein RC-Modul (80) mit einem keramischen Kondensator (81) und mindestens einem Dickschichtwiderstand (82-85) aufweist, der in die Oberfläche des keramischen Kondensators (81) oder eines Keramikträgers (89) integriert ist.

7. RC-Spannungsteiler nach Anspruch 6, **dadurch gekennzeichnet, dass** der keramische Kondensator (81) des Sekundärteils (2) scheibenförmig ausgebildet ist und die beiden Flachseiten des keramischen Kondensators (81) eine Metallisierung (86, 87) aufweisen, wobei auf der dem keramischen Kondensator (81) abgewandten Seite der einen Metallisierung (87) der Keramikträger (89) mit dem oder den integrierten Dickschichtwiderständen (82-85) angeordnet ist und wobei vorzugsweise eine gerade Anzahl symmetrisch angeordneter Dickschichtwiderstände (82-85) vorhanden ist.

8. RC-Spannungsteiler nach einem der Ansprüche 1 bis 7, **dadurch gekennzeichnet, dass** am Sekundärteil (2) eine symmetrische Anschlussverdrahtung (90-93) für die Abnahme der Sekundärspannung $U_s$ vorhanden ist, wobei an die Anschlussverdrahtung (90-93) vorzugsweise eine verdrillte Messleitung (94) angeschlossen ist, die mit einer einfachen oder zweifachen Abschirmung (95) versehen sein kann.

9. RC-Spannungsteiler nach einem der Ansprüche 1 bis 8, **dadurch gekennzeichnet, dass** zwischen den einzelnen RC-Modulen (20; 40; 60; 80) Potentialringe (11) zur Vergleichmässigung des elektrischen Feldes angeordnet sind.

## Claims

1. RC voltage divider for the measurement of the primary voltage Up between phase and earth or between phase and a neutral conductor in single-phase, two-phase and three-phase systems, having a primary part (1) and a secondary part (2), **characterized in that** the primary part (1) has at least one RC module (20; 40; 60) with a ceramic capacitor (21; 41; 61) and at least one thick-film resistor (22, 23; 42-45; 62-65) which is integrated in the surface of the ceramic capacitor (21; 41; 61).

**2.** RC voltage divider according to Claim 1, **characterized in that** the thick-film resistor or resistors (22, 23; 42-45; 62-65) is or are burnt into the surface of the ceramic capacitor (21; 41; 61) and preferably has or have a meandering profile.

**3.** RC voltage divider according to Claim 1 or 2, **characterized in that** the ceramic capacitor (21; 41; 61) is in the form of a solid-core cylinder or a hollow-core cylinder, with the two end surfaces of the cylinder preferably having metallization (26, 27; 46, 47; 66, 67).

**4.** RC voltage divider according to Claim 3, **characterized in that** the thick-film resistor or resistors (22, 23) runs or run on the cylindrical casing surface of the ceramic capacitor (21), in particular in a straight line from one end surface to the other and at right angles to the two end surfaces, and has or have metallic connections (221, 222, 231, 232) .

**5.** RC voltage divider according to Claim 3, **characterized in that** the thick-film resistor or resistors (42-45; 62-65) runs or run essentially on the cylindrical casing surface of the ceramic capacitor (41; 61), in particular in a straight line from one end surface to the other and at right angles to the two end surfaces, and has or have metallic connections (421, 422, 431, 432, 441, 442, 451, 452; 621, 622, 631, 632, 641, 642, 651, 652) which are arranged on the end surfaces.

**6.** RC voltage divider according to one of Claims 1 to 5, **characterized in that** the secondary part (2) has an RC module (80) with a ceramic capacitor (81) and at least one thick-film resistor (82-85) which is integrated in the surface of the ceramic capacitor (81) or of a ceramic mount (89).

**7.** RC voltage divider according to Claim 6, **characterized in that** the ceramic capacitor (81) in the secondary part (2) is in the form of a disc, and the two flat faces of the ceramic capacitor (81) have metallization (86, 87), with the ceramic mount (89) with the integrated thick-film resistor or resistors (82-85) being arranged on the side of the first metallization (87) facing away from the ceramic capacitor (81), and with an even number of symmetrically arranged thick-film resistors (82-85) preferably being provided.

**8.** RC voltage divider according to one of Claims 1 to 7, **characterized in that** symmetrical connecting wiring (90-93) is provided on the secondary part (2) for tapping off the secondary voltage $U_s$, in which

case a twisted measurement line (94) is preferably connected to the connecting wiring (90-93) and can be provided with a single or double screen (95).

**9.** RC voltage divider according to one of Claims 1 to 8, **characterized in that** potential rings (11) are arranged between the individual RC modules (20; 40; 60; 80) in order to make the electrical field uniform.

## Revendications

**1.** Diviseur de tension RC pour la mesure de la tension primaire $U_p$ entre la phase et la terre ou entre la phase et le fil neutre dans des systèmes monophasés, biphasés ou triphasés, composé d'une partie primaire (1) et d'une partie secondaire (2), **caractérisé en ce que** la partie primaire (1) présente au moins un module RC (20 ; 40 ; 60) muni d'un condensateur céramique (21 ; 41 ; 61) et au moins une résistance en couche épaisse (22, 23 ; 42-45 ; 62-65) intégrée dans la surface du condensateur céramique (21 ; 41 ; 61).

**2.** Diviseur de tension RC selon la revendication 1, **caractérisé en ce que** la ou les résistances en couche épaisse (22, 23 ; 42-45 ; 62-65) est/sont recuite(s) et de préférence s'étendent en formant des méandres sur toute la surface du condensateur céramique (21 ; 41 ; 61).

**3.** Diviseur de tension RC selon la revendication 1 ou 2, **caractérisé en ce que** le condensateur céramique (21 ; 41 ; 61) est formé comme un cylindre plein ou creux, les deux surfaces d'extrémité du cylindre présentant de préférence une métallisation (26, 27 ; 46, 47 ; 66, 67).

**4.** Diviseur de tension RC selon la revendication 3, **caractérisé en ce que** la ou les résistances en couche épaisse (22, 23) s'étend/s'étendent sur toute la surface du corps du cylindre du condensateur céramique (21), notamment suivant une ligne droite partant de l'une des surfaces d'extrémité jusqu'à l'autre et verticalement aux deux surfaces d'extrémité, et présente/présentent des connexions métalliques (221, 222, 231, 232).

**5.** Diviseur de tension RC selon la revendication 3, **caractérisé en ce que** la ou les résistances en couche épaisse (42-45 ; 62-65) s'étend/s'étendent essentiellement sur toute la surface du corps du cylindre du condensateur céramique (41 ; 61), notamment suivant une ligne droite partant de l'une des surfaces d'extrémité jusqu'à l'autre et verticalement aux deux surfaces d'extrémité, et présente/présentent des connexions métalliques (421, 422, 431, 432, 441, 442, 451, 452 ; 621, 622, 631, 632, 641, 642, 651,

**EP 0 980 003 B1**

652) disposées au niveau des surfaces d'extrémité.

6. Diviseur de tension RC selon l'une des revendications 1 à 5, **caractérisé en ce que** la partie secondaire (2) présente un module RC (80) muni d'un condensateur céramique (81) et d'au moins une résistance en couche épaisse (82-85) intégrée dans la surface du condensateur céramique (81) ou d'un support en céramique (89).

7. Diviseur de tension RC selon la revendication 6, **caractérisé en ce que** le condensateur céramique (81) de la partie secondaire (2) est en forme de disque et que les deux côtés plats du condensateur céramique (81) présentent une métallisation (86, 87), le support en céramique (89) avec la ou les résistances en couche épaisse intégrées (82-85) étant disposé sur le côté de l'une des métallisations (87) qui est opposé du condensateur céramique (81), et de préférence un nombre pair de résistances en couche épaisse (82-85) disposées de façon symétrique étant disponibles.

8. Diviseur de tension RC selon l'une des revendications 1 à 7, **caractérisé en ce qu'**un câblage symétrique des connexions (90-93) est disponible au niveau de la partie secondaire (2) pour la dérivation de tension secondaire $U_s$, une conduite de mesure (94) torsadée, pouvant être pourvue d'un blindage (95) simple ou double, étant de préférence raccordée au câblage des connexions (90-93).

9. Diviseur de tension RC selon l'une des revendications 1 à 8, **caractérisé en ce que** des anneaux de garde (11) sont disposés entre les différents modules RC (20 ; 40 ; 60 ; 80) pour homogénéiser le champ électrique.

# FIG.1

# FIG.2

# FIG.3

# FIG.4

**FIG.5**

**FIG.6**

## FIG.7

## FIG.8

FIG.9

FIG.10

FIG.11

FIG.12